**Europäisches Patentamt**

**European Patent Office**

**Office européen des brevets**

(19)

(11) Veröffentlichungsnummer: **0 101 592**
A2

# EUROPÄISCHE PATENTANMELDUNG

(12)

(21) Anmeldenummer: **83107764.9**

(22) Anmeldetag: **06.08.83**

(51) Int. Cl.³: **H 01 L 23/48**

(30) Priorität: **14.08.82 DE 3230376**

(43) Veröffentlichungstag der Anmeldung: **29.02.84**
**Patentblatt 84/9**

(84) Benannte Vertragsstaaten: **CH DE FR GB IT LI NL**

(71) Anmelder: **DEMETRON Gesellschaft für Elektronik-Werkstoffe m.b.H., Leipziger Strasse 10, D-6450 Hanau 1 (DE)**

(72) Erfinder: **Rusbüldt, Volker, Dr., Dipl.-Ing., Wildaustrasse 14, D-6450 Hanau 9 (DE)**
Erfinder: **Schlamp, Günther, Dr., Dipl.-Chem., Stettiner Strasse 25, D-6374 Steinbach/Ts. (DE)**
Erfinder: **Martin, Wolfram, Dr., Dipl.-Phys., 10, First Avenue, SG-Singapore 1026 (SG)**

(54) **Golddraht für Halbleiterbauelemente.**

(57) Bekannte Drähte aus Gold und Goldlegierungen zum Verbinden von Halbleiterkristallen mit Anschlußstellen am Systemträger zeigen beim automatischen Bonden oft Durchhängungen, Verwehungen und Überschußlängen. Diese vermeidet man, wenn die Kristallite im Draht zu mindestens 50% eine Vorzugsorientierung in Achsrichtung entsprechend einer ‹100›-Fasertextur aufweisen.

82 163 DM

D e m e t r o n

6450 Hanau 1, Leipziger Straße 10

Golddraht für Halbleiterbauelemente

Die Erfindung betrifft einen Draht aus Gold oder Goldlegierungen zum Verbinden von Halbleiterkristallen in Halbleiterbauelementen mit Anschlußstellen.

Dünne Drähte aus Gold- oder Goldlegierungen werden in der Halbleitertechnik zum Verbinden der Halbleiterkristalle mit den Anschlußstellen am Gehäuse bzw. den Anschlußstellen am Systemträger benützt. Dabei wird üblicherweise der Kontakt am Halbleiterkristall durch Anpressen einer vorher am Draht durch Anschmelzen erzeugten Kugel hergestellt (sog. "ball-bonding"). Am Systemträger wird der Draht mittels einer speziell geformten Kante eines Stempels mit der Anschlußstelle verbunden (sog. "wedge-bonding"). In beiden Fällen erfolgt die Zuführung des Drahtes von einer Vorratsspule her über Greiferzangen durch eine sogenannte Bondkapillare. Diese hat an der Austrittstelle des Drahtes eine Kante, mittels derer der Draht an die Anschlußstelle gepreßt und dabei mit dieser verbunden wird.

Dieses Bondverfahren eignet sich hervorragend für eine vollautomatische Fertigung. Entsprechend wurden in den letzten Jahren dafür automatische Hochleistungs-Geräte entwickelt, die bis zu vier und mehr Drahtverbindungsbögen pro Sekunde zwischen Halbleiterkristall und Anschlußstelle herstellen. Der dünne Draht ist beim Bondvorgang sowohl während der Zuführung mittels der Greiferzangen in die Kapillare als auch beim Herstellen des Verbindungsbogens beträchtlichen mechanischen Beanspruchungen ausgesetzt. Diese Beanspruchungen liegen zum Teil im Bereich der elastischen Verformungen, reicher aber bei der Ausbildung des Verbindungsbogens bereits in das Gebiet der plastischen Verformung. Bei komplexen integrierten Schaltungen werden an einem einzigen Kristall oft zahlreiche Drahtverbindungen, z. B. 24 oder 48 Anschlüsse, hergestellt, die sich im allgemeinen hinsichtlich der zu verbindenden Abstände und der Höhe der zu überbrückenden Zwischenräume erheblich unterscheiden.

Es hat sich gezeigt, daß seit Einführung der Automatik-Schnellbondgeräte mit zunehmender Bondgeschwindigkeit, mit zunehmenden Unterschieden von Drahtlängen und Höhengeometrien bei den klassischen Golddrähten erhebliche Verbindungsfehler entstehen können. Die gefürchtetsten sind das Durchhängen der Bögen ("sagging"), das zu Kurzschlüssen innerhalb des Bauelementes führen kann, ferner die sogenannten "Verwehungen", bei denen der Bogen insgesamt geneigt oder verdreht wird, sowie die Überschußlängen, die zur Bildung von Knicken im Drahtbogen führen. Diese Effekte, die durch die sehr unterschiedliche Beanspruchung beim Herstellen der verschiedenen Drahtbögen aus einem Draht mit vorgegebenen Reißlast- und Dehnungswerten in den üblichen Toleranzen hervorgerufen werden, ergeben ernste Probleme bei der vollautomatischen Halbleiterfertigung.

Es war daher Aufgabe der vorliegenden Erfindung, einen Draht aus Gold oder Goldlegierungen zum Verbinden von Halbleiterkristallen in Halbleiterbauelementen mit Anschlußstellen zu schaffen, bei dem die Durchhängung der Bögen, die sogenannten Verwehungen sowie die Überschußlängen zuverlässig vermieden werden.

Diese Aufgabe wurde erfindungsgemäß dadurch gelöst, daß die Kristallite im Draht zu mindestens 50 % eine Vorzugsorientierung in Achsrichtung entsprechend einer $\langle 100 \rangle$-Fasertextur besitzen.

Die erfindungsgemäßen Gold- bzw. Goldlegierungsdrähte vermeiden die angesprochenen Schwierigkeiten der bekannten Drähte. Es wurde überraschenderweise gefunden, daß Gold- bzw. Goldlegierungsdrähte, deren Durchmesser vorzugsweise im Bereich von 12 $\mu$m bis zu 150 $\mu$m liegen, bei den üblichen Bondverfahren dann keine durchhängenden Bögen, Verwehungen und Überschußlängen ausbilden, wenn die Drähte in der Richtung der Drahtachse eine ausgeprägte Fasertextur der Kristallkörner in $\langle 100 \rangle$-Orientierung besitzen. Besonders vorteilhaft ist eine Doppelfasertextur, die neben den in $\langle 100 \rangle$-Fasertextur orientierten Anteilen im wesentlichen nur noch solche enthält, die in $\langle 111 \rangle$-Textur orientiert sind. Wesentlich dabei ist, daß die relativen Mengenanteile der vorliegenden Kristallorientierungen so bemessen sind, daß mindestens 50 %, vorzugsweise über 65 % der Kristallkörner in der $\langle 100 \rangle$ Fasertextur vorliegen. Als besonders günstig hat es sich erwiesen, wenn bei gleichzeitiger Anwesenheit von $\langle 100 \rangle$-und $\langle 111 \rangle$-orientierten Fasertexturanteilen diese so angeordnet sind, daß die $\langle 111 \rangle$-Lagen sich bevorzugt im Innern des Drahtes in Längsrichtung der Drahtachse und die nach $\langle 100 \rangle$ orientierten Anteile sich in der Oberflächenschicht, daß heißt im Mantelbereich des Drahtes, ebenfalls in Richtung der Längsachse befinden.

Die Ausbildung von Vorzugsorientierungen der Kristallite in Drähten ist an sich bekannt. So kann man beispielsweise durch Glühen eines Golddrahtes bei 300°C über einen Zeitraum von 30 Minuten eine ausgeprägte $\langle 100 \rangle$-Fasertextur erzielen. Den Golddrähten können zwecks Erzielung bestimmter mechanischer Eigenschaften, wie zum Beispiel Reißlast und Dehnung, bestimmte, für diese Zwecke bekannte, Elemente zulegiert werden. Es ist beispielsweise bekannt, Golddrähte mit 3 bis 10 ppm Beryllium zu verwenden, um eine genügende Reißlast bei vorgegebener Dehnung zu erzielen.

Solche oder ähnliche Legierungen ohne Textur genügen jedoch nicht, um eine sichere und gleichmäßige Bondqualität, speziell bei Verwendung von schnellen Automatikbondern, zu gewährleisten. Erzeugt man allerdings bei solchen Drähten die erfindungsgemäßen Vorzugsorientierungen der Kristallite im Draht, so erhält man voll funktionsfähige und störungsfrei arbeitende Bonddrähte. Glühzeit und Glühtemperatur, die zur Erzeugung der erforderlichen Texturen benötigt werden, hängen dabei vom Legierungssystem des Drahtes und den jeweiligen Drahtdurchmessern ab. Sie können durch einige Handversuche leicht bestimmt werden. Die ideale Ausbildung einer völligen Texturausrichtung nach $\langle 100 \rangle$ und $\langle 111 \rangle$ ist allerdings nur in den seltensten Fällen möglich. Im Normalfall befindet sich ein kleiner Teil der Kristallite noch in ungeordneten Streulagen.

- 5 -

0101592

82 163 DM

Demetron

6450 Hanau 1, Leipziger Straße 10

**Patentansprüche**

1. Draht aus Gold oder Goldlegierungen zum Verbinden von Halbleiterkristallen in Halbleiterbauelementen mit Anschlußstellen, dadurch gekennzeichnet, daß die Kristallite im Draht zu mindestens 50 % eine Vorzugsorientierung in Achsrichtung entsprechend einer $\langle 100 \rangle$ -Fasertextur besitzen.

2. Draht nach Anspruch 1, dadurch gekennzeichnet, daß die Kristallite zu mindestens 65 % eine $\langle 100 \rangle$ -Fasertextur aufweisen.

3. Draht nach Anspruch 1 und 2, dadurch gekennzeichnet, daß die übrigen Kristallite im wesentlichen in einer $\langle 111 \rangle$ -Fasertextur ausgerichtet sind.

4. Draht nach Anspruch 1 bis 3, dadurch gekennzeichnet, daß die $\langle 111 \rangle$-Fasertextur in der Drahtseele und die $\langle 100 \rangle$ -Fasertextur in der Oberflächenschicht des Drahtes ausgebildet sind.

5. Draht nach Anspruch 1 bis 4, dadurch gekennzeichnet, daß er einen Durchmesser von 12 bis 150 $\mu$m aufweist.